# EUROPEAN PATENT APPLICATION

(11) **EP 4 535 019 A1**
(43) Date of publication of application: **09.04.2025**
(21) Application number: 24814647.4
(22) Date of filing: 26.06.2024
(51) Int. Cl.: G01R 31/36, G01R 31/382, G01R 31/3835, G01R 31/385, G01N 17/00

(54) **CELL INSPECTION METHOD AND APPARATUS, AND ELECTRONIC DEVICE**

(30) Priority: 26.06.2023 CN 202310764594
(71) Applicant: Eve Power Co., Ltd., Jingmen, Hubei 448000 (CN)
(72) Inventor: YI, Yanhui, Jingmen, Hubei 448000 (CN); YUAN, Dingding, Jingmen, Hubei 448000 (CN); TAN, Xianyang, Jingmen, Hubei 448000 (CN); LIU, Jincheng, Jingmen, Hubei 448000 (CN)
(74) Representative: Glawe, Delfs, Moll
(86) International application number: PCT/CN2024/101642
(87) International publication number: WO 2024/245454

(57) **Abstract**

Provided is a battery testing method. The battery testing method includes: providing a tested battery, where the tested battery includes a first case, a first positive electrode and a first negative electrode (S101); determining a reference voltage range (S102); and measuring a tested voltage between the first positive electrode and the first case of the tested battery, and determining that the battery is normal in response to determining that the tested voltage is within the reference voltage range (S103); where the determining the reference voltage range includes: providing a plurality of reference batteries, measuring a voltage between a first positive electrodes and a first case of each of the plurality of reference batteries, and obtaining V₁ (S1); providing a plurality of three-electrode batteries, measuring a voltage between a second positive electrode and a reference electrode of each of the plurality of three-electrode battery, and obtaining V₂ (S2); connecting resistors that have different resistance values between one electrodes of the first positive electrodes and first negative electrodes of all of the plurality of reference batteries and the first cases (S3); measuring the voltage between the first positive electrode of each of the plurality of reference batteries and the first case of each of the plurality of reference batteries and obtaining V₃ (S4); and obtaining the reference voltage range V=V₃+(V₁-V₂) as claimed in V₁, V₂ and V₃ (S5). As claimed in the invention, the reference voltage range obtained by the battery testing method has high accuracy, and accuracy of detection for battery failure may be improved.

## Description

### Cross-Reference to Related Application

The disclosure claims the priority to Chinese Patent Application No. 202310764594.2 filed with the Chinese Patent Office on June 26, 2023.

### Technical Field

The invention relates to the technical field of batteries, for example, relates to a battery testing method.

### Background

During battery production or use process, lithium ions will be inserted in aluminum cases through electrolytes during charging and discharging by a high probability of direct contact of positive electrodes and negative electrodes of the batteries with the cases. Once the battery cases are corroded or even leaked due to generation of lithium inserted compounds, normal production or use of batteries is likely to be affected.

At present, a battery generally has a structure with a positive electrode electrically connected to a case and a negative electrode insulated from the case, that is, the battery is single-insulated battery. Whether the single-insulated battery is corroded is determined by monitoring in real time a voltage between the positive electrode and the case. A battery corrosion failure is indicated if the voltage between the positive electrode and the case exceeds a voltage boundary value for case corrosion. A range of the voltage boundary value is determined based on voltages measured between positive electrodes and cases of numerous batteries that are being corroded. Accuracy of the voltage measured between the positive electrode and the case may be guaranteed due to a negligible potential between the case and the electrolyte of the single-insulated battery.

In a battery with its positive electrode and negative electrode insulated from its case, that is, the battery is double-insulated battery, ion channels exist among the electrodes, an electrolyte and the case, and a potential exists between the case and the electrolyte. As a result, a voltage between a positive electrode and the case of the double-insulated battery obtained through direct monitoring is likely to include the potential between the case and the electrolyte. If the method for determining the voltage boundary value of the single-insulated battery is still used to determine a range of a voltage boundary value of the double-insulated battery for case corrosion, it is necessary to electrically connect the positive electrode to the case of the double-insulated battery before monitoring in real time voltages between positive electrodes and cases of numerous of the double-insulated batteries that are being corroded.

### Summary

### Technical Problems

Electrical conduction between a positive electrode and a case of a double-insulated battery is equivalent to electrical conduction between a battery serving as the positive electrode and the case. A negative electrode and the case of the double-insulated battery are still insulated from each other, that is, the double-insulated battery becomes a single-insulated battery equivalently. Thus, a voltage between the positive electrode and the case of the double-insulated battery measured in a test does not include a potential between the case and an electrolyte. Thus, a range of a voltage boundary value obtained by adopting the single-insulated battery for testing the voltage boundary value when the case is corroded may be small, and a battery that does not have a corrosion failure but exceeds the range of voltage boundary value is likely to be determined to have a corrosion failure. As a result, testing accuracy is reduced.

### Solutions

In an embodiment of the invention, the invention provides a battery testing method. The battery testing method includes:
providing a tested battery, where the tested battery includes a first case and electrodes, the electrodes include a first positive electrode and a first negative electrode, and the first positive electrode and the first negative electrode are both insulated from the first case;
determining a reference voltage range; and
measuring a tested voltage between the first positive electrode and the first case of the tested battery, determining whether the tested voltage is within the reference voltage range, and determining that the tested battery is normal in response to determining that the tested voltage is within the reference voltage range; where
the determining the reference voltage range includes:
   providing a plurality of reference batteries that have the same structure as the tested battery, and determining a voltage range V₁ of the plurality of reference batteries in a normal working state according to a voltage measured between a first positive electrode of each of the plurality of reference batteries and a first case of each of the plurality of reference batteries;
   providing a plurality of three-electrode batteries, where each of the plurality of three-electrode batteries includes a second case, and a second positive electrode, a second negative electrode and a reference electrode that are all insulated from the second case, and the reference electrode is made from the same material as the first case; and measuring a voltage between the second positive electrode and the reference electrode of each of the plurality of three-electrode batteries, and obtaining a voltage range V₂ of the plurality of reference batteries in a normal working state;
   connecting a resistor between one electrode of the first positive electrode and a first negative electrode of each of the plurality of reference batteries, and the first case of each of the plurality of reference batteries, where resistance values of resistors connected to the plurality of reference batteries vary from one another;
   measuring a voltage between the first positive electrode of each of the plurality of reference batteries and the first case of each of the plurality of reference batteries, and obtaining a voltage range V₃ according to the voltage between the first positive electrode and the first case of each of the plurality of reference batteries when each of the plurality of reference batteries is not corroded; and
   obtaining the reference voltage range V=V₃+(V₁-V₂) according to V₁, V₂ and V₃.

In another embodiment of the invention, a battery testing apparatus is provided. The battery testing apparatus includes:
a battery supply assembly configured to provide a tested battery, a plurality of reference batteries and a plurality of three-electrode batteries, where the tested battery includes a first case and electrodes; the electrodes include a first positive electrode and a first negative electrode, and the first positive electrode and the first negative electrode are both insulated from the first case; and the plurality of reference batteries have the same structure as the tested battery, each of the plurality of three-electrode batteries includes a second case, and a second positive electrode, a second negative electrode and a reference electrode that are all insulated from the second case, and the reference electrode is made from the same material as the first case;
a reference voltage range determination module configured to determine a voltage range V₁ of the plurality of reference batteries in a normal working state according to a voltage measured between a first positive electrode and a first case of each of the plurality of reference batteries; measure a voltage between the second positive electrode and the reference electrode of each of the plurality of three-electrode batteries, and obtain a voltage range V₂ of the plurality of three-electrode batteries in a normal working state; connect a resistor between one electrode of the first positive electrode of each of the plurality of reference batteries and a first negative electrode of each of the plurality of reference batteries, and the first case of each of the plurality of reference batteries, where resistance values of resistors connected to the plurality of reference batteries vary from one another; measure the voltage between the first positive electrode and the first case of each of the plurality of reference batteries, and obtain a voltage range V₃ according to the voltage between the first positive electrode and the first case of each of the plurality of reference batteries when each of the plurality of reference batteries is not corroded; and obtain the reference voltage range V=V₃+(V₁-V₂) according to V₁, V₂ and V₃; and
a battery state determination module configured to measure a tested voltage between the first positive electrode of the tested battery and the first case of the tested battery, determine whether the tested voltage is within the reference voltage range, and determine that the tested battery is normal in response to determining that the tested voltage is within the reference voltage range.

In another embodiment of the invention, an electronic device is provided. The electronic device includes: at least one processor and a memory; and a memory in communication connection to the at least one processor; where
the memory stores a computer instruction executable by the at least one processor, and the computer instruction causes the at least one processor to be capable of executing the battery testing method according to any embodiment when executed by the at least one processor.

### Beneficial effects

The invention has beneficial effects as follows:
Since the reference electrode is made from the same material as the first case of each of the plurality of reference batteries, the second electrode is equivalent to the first electrode. The voltage range V₂ measured according to the voltage between the second positive electrode and the reference electrode is equivalent to a voltage range measured according to the voltage between the first positive electrode of each of the plurality of reference batteries and the first case of each of the plurality of reference batteries, and V₂ does not include a potential between the electrolyte and the first case of each of the plurality of reference batteries. By comparing V₁ and V₂, whether the voltage directly measured between the first positive electrode of each of the plurality of reference batteries and the first case of each of the plurality of reference batteries includes the potential between the first case and the electrolyte may be determined. The potential between the first case and the electrolyte may be obtained according to a difference between V₁ and V₂. The voltage range V₃ according to the voltage between the first positive electrode and the first case of each of the plurality of reference batteries when each of the plurality of reference batteries is not corroded is obtained by simulating a short-circuit failure of each of the plurality of reference batteries and does not include the potential between the electrolyte and the case. Thus, compensation for the potential between the first case of each of the plurality of reference batteries and the electrolyte may be implemented by correcting the voltage range V₃, and the reference voltage range V when the case of the double-insulated battery is corroded may be obtained. Thus, accuracy of the reference voltage range V is improved, and failure detection of the double-insulated battery is more accurate.

### Brief Description of the Drawings

Fig. 1A is a schematic flowchart of a battery testing method according to some embodiments of the invention.
Fig. 1B is a schematic flowchart of a method for determining a reference voltage range according to some embodiments of the invention.
Fig. 2 is a schematic structural diagram of a three-electrode battery according to some embodiments of the invention.
Fig. 3 is a scanning electron microscope (SEM) image of a first case that is not corroded according to some embodiments of the invention.
Fig. 4 is an SEM image of a first case that is corroded according to some embodiments of the invention.
Fig. 5 is a structural block diagram of a battery testing apparatus according to some embodiments of the invention.
Fig. 6 is a structural diagram of a tested battery according to some embodiments of the invention.

In the figures:
1. second case; 2. second positive electrode; 3. second negative electrode; 4. reference electrode; 41. first section; 42. second section; and 5. core.

### Detailed Description

In the invention, unless expressly specified and defined otherwise, the terms such as "connected", "connection" and "fix" should be understood broadly, and may denote, for example, fixed connection, detachable connection, integrated connection, mechanical connection, electric connection, direct connection, indirect connection through an intermediate medium, communication between interiors of two elements or interaction between two elements. For a person of ordinary skill in the art, specific meanings of the above terms in the invention may be understood according to specific circumstances.

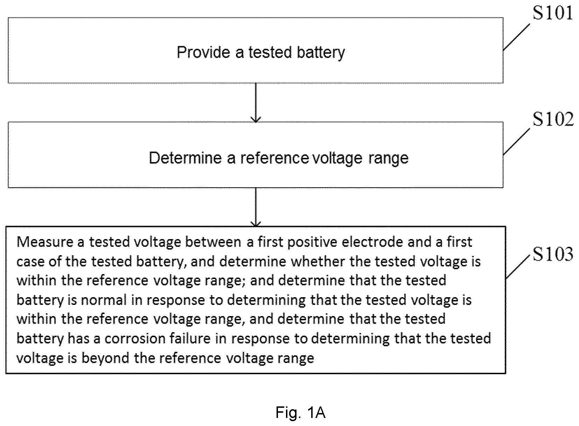

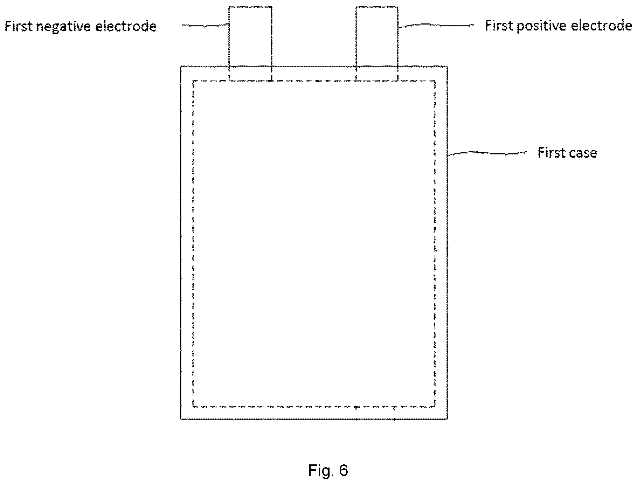

The invention provides a battery testing method. The battery testing method is configured to test whether the battery has a corrosion failure. As shown in Fig. 1A, the battery testing method includes:
S101. A tested battery is provided, where the tested battery includes a first case and electrodes, the electrodes include a first positive electrode and a first negative electrode (as shown in Fig. 6), and the first positive electrode and the first negative electrode are both insulated from the first case, that is, the tested battery is a double-insulated battery.
S102. A reference voltage range is determined.
S103. A tested voltage between a first positive electrode and a first case of the tested battery is measured, and whether the tested voltage is within the reference voltage range is determined. It is determined that the tested battery is normal in response to determining that the tested voltage is within the reference voltage range, and it is determined that the tested battery has a corrosion failure in response to determining that the tested voltage is beyond the reference voltage range, that is, the first case of the tested battery is corroded.

By the battery testing method, a change in the tested voltage between the first positive electrode and the first case of the tested voltage may be monitored in real time, the phenomenon that corrosion of the first case of the tested battery leads to the corrosion failure of the battery is detected, and an alarm is given in time. Thus, threat to personal safety of a user due to abnormal operation of the battery is avoided.

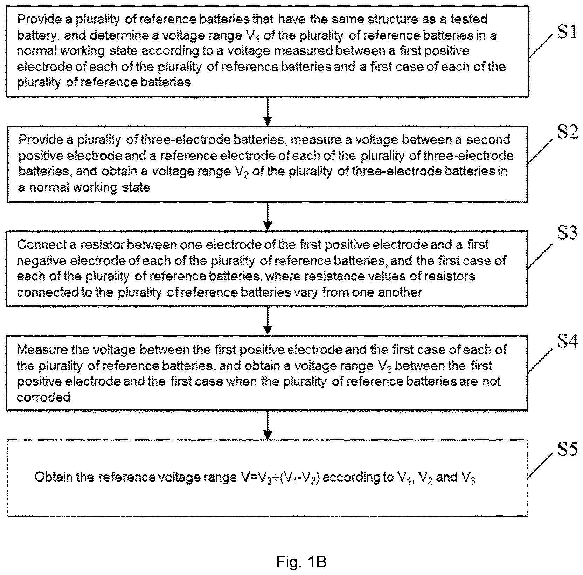

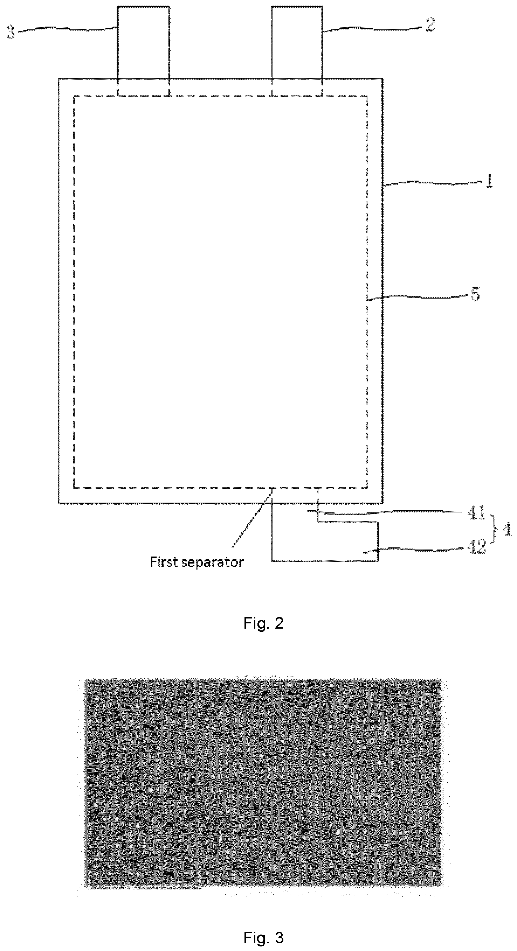

With reference to Figs. 1B and 2, the reference voltage range is obtained by the following steps.

S1. A plurality of reference batteries that have the same structure as the tested battery are provided, and a voltage range V₁ of the plurality of reference batteries in a normal working state is determined by measuring voltages between first positive electrodes and first cases of all of the plurality of reference batteries.

S2. A plurality of three-electrode batteries are provided, where each of the plurality of three-electrode batteries includes a second case 1, and a second positive electrode 2, a second negative electrode 3 and a reference electrode 4 that are all insulated from the second case 1, the reference electrode 4 is made from the same material as the first case of each of the plurality of reference batteries, and each of the plurality of three-electrode batteries has the same structure as the tested battery except for the reference electrode 4 and the second case 1. A voltage between the second positive electrode 2 and the reference electrode 4 of each of the plurality of three-electrode batteries is measured, and a voltage range V₂ of the plurality of three-electrode batteries in a normal working state is obtained.

Since the reference electrode 4 is made from the same material as the first case of each of the plurality of reference batteries, the second positive electrode 2 is equivalent to the first positive electrode, and V₂ measured according to the voltage between the second positive electrode 2 and the reference electrode 4 is equivalent to the voltage measured between the first positive electrode of each of the plurality of reference batteries and the first case of each of the plurality of reference batteries. V₂ does not include the potential between the electrolyte and the first case.

S3. A resistor is connected between one electrode of the first positive electrode of each of the plurality of reference batteries and a first negative electrode of each of the plurality of reference batteries, and the first case of each of the plurality of reference batteries, for simulating a short-circuit failure caused by contact between a case and an electrode of a battery. Resistance values of resistors connected to all of the plurality of reference batteries vary from one another.

S4. The voltage between the first positive electrode of each of the plurality of reference batteries and the first case of each of the plurality of reference batteries is measured, and the voltage range V₃ according to the voltage between the first positive electrode of each of the plurality of reference batteries and the first case of each of the plurality of reference batteries when each of the plurality of reference batteries is not corroded is obtained.

One electrode of the first positive electrode and a first negative of each of the plurality of reference batteries is electrically connected to the first case of each of the plurality of reference batteries through the resistor, and the other electrode is still insulated from the first case. Thus, a double-insulated reference battery is changed into a single-insulated reference battery equivalently, and the measured V₃ does not include the potential between the electrolyte and the first case.

S5. The reference voltage range V=V₃+(V₁-V₂) is obtained according to V₁, V₂ and V₃.

In a method for determining the reference voltage range, whether the voltage between the first positive electrode of each of the plurality of reference batteries and the first case of each of the plurality of reference batteries includes the potential between the first case of each of the plurality of reference batteries and the electrolyte may be determined according to a difference between V₁ and V₂. If there is a difference between V₁ and V₂, it means that the voltage directly measured between the first positive electrode of each of the plurality of reference batteries and the first case of each of the plurality of reference batteries includes the potential between the first case of each of the plurality of reference batteries and the electrolyte. Thus, it is necessary to increase the potential between the first case of each of the plurality of reference batteries and the electrolyte of each of the plurality of reference batteries in V₃ to correct the reference voltage range V. If V₁ and V₂ are equal, it means that the voltage directly measured between the first positive electrode of each of the plurality of reference batteries and the first case of each of the plurality of reference batteries does not include the potential between the first case of each of the plurality of reference batteries and the electrolyte. Thus, the reference voltage range obtained by the solution of the invention is more accurate, the condition that a double-insulated battery that does not have a corrosion failure is determined as a double-insulated battery that has a corrosion failure is reduced, and testing accuracy is improved.

In an embodiment, V₁ is range from 0.5 V to 0.7 V, and V₂ is range from 0.35 V to 0.5 V. The inventor determines through tests that there is indeed a difference between V₁ and V₂. Thus, when the double-insulated battery is tested, the voltage directly measured between the first positive electrode and the first case includes the potential between the first case and the electrolyte.

In an embodiment, in S4, the measured V₃ is smaller than 1.15 V.

According to test data, the reference voltage range is smaller than 1.3 V, that is, the reference voltage range of the double-insulated battery is smaller than 1.3 V. If the tested voltage monitored of the double-insulated battery is higher than 1.3 V, it indicates that the battery has a corrosion failure.

In an embodiment, the first case is an aluminum case or a steel case.

In an embodiment, S2 includes:
S201. A first case of each of the plurality of reference batteries which is qualified is provided, the first case of each of the plurality of reference batteries is cut into a strip-shaped piece, and the strip-shaped piece is polished with sandpaper to remove burrs.
S202. An outer side of the strip-shaped piece is coated with a first separator.
S203. A core 5 of each of the plurality of reference batteries is provided as a core 5 of each of the plurality of three-electrode batteries, and an end of the strip-shaped piece is inserted into the core 5 and forms a reference electrode 4.
S204. A second case 1 and an electrolyte are provided, the core 5 is mounted into the second case 1, the electrolyte is injected into the second case 1, the second case 1 is packaged, and each of the plurality of three-electrode batteries is manufactured. An end, far away from the core 5, of the reference electrode 4 extends out of the second case 1 to an exterior of the second case 1.

The reference electrode 4 may be separated from the core 5 and the electrolyte through the first separator, and it is guaranteed that the voltage measured between the reference electrode 4 and the second positive electrode 2 does not include the potential between the reference electrode 4 and the electrolyte. Thus, potential existence between the reference electrode 4 and the electrolyte is prevented from interfering with accuracy of a test result.

In an embodiment, in S202, the outer side of the strip-shaped piece is completely coated with the first separator. Alternatively, a part, located in the second case 1, of the strip-shaped piece is coated with the first separator for saving the first separator.

In an embodiment, the core 5 includes a positive plate, a negative plate and a second separator arranged between the negative plate and the positive plate, and an end, inserted into the core 5, of the reference electrode 4 is located between the negative plate and the second separator. In this design, the reference electrode 4 is directly inserted into the core 5, existing components and structures of the three-electrode battery itself are fully utilized and other accessories are no longer needed to be introduced. Thus, assembly efficiency of the three-electrode battery may be greatly improved, and interference factors caused by introduction of other accessories may be avoided.

The three-electrode battery is a pouch battery, and the second case 1 of the three-electrode battery is made from an aluminum-plastic film. The three-electrode battery packaged with the aluminum-plastic film is convenient and quick to assemble and disassemble, thus improving testing efficiency.

The core 5 includes a positive tab and a negative tab. The positive tab is connected to the positive plate, and the negative tab is connected to the negative plate. The positive tab and the negative tab both extend out of the second case 1 to an exterior of the second case 1, so as to form the second positive electrode 2 and the second negative electrode 3, thereby connecting the positive plate and the negative plate to external circuits advantageously for testing work.

A portion, outside the second case 1, of the reference electrode 4 is located on a side of the second case 1 other than a side where the positive tab and the negative tab are located. Since the three-electrode battery is packaged with the aluminum-plastic film, the reference electrode 4 as well as the positive tab and the negative tab are arranged separated on different sides of the second case 1 before packaging, thus reasonably using space and reducing packaging difficulty.

In an embodiment, in S201, the strip-shaped piece is cut into a first section 41 and a second section 42 that form an included angle therebetween. In the embodiment, the reference electrode 4 is L-shaped, and the first section 41 and the second section 42 are perpendicular to each other. In S204, the second case 1 is provided with a via hole, and an end, far away from the second section 42, of the first section 41 is inserted into the second case 1 through the via hole and vertically inserted into a position between the negative plate and the second separator. That is, the first section 41 and the core 5 are perpendicularly connected, at least a part of the first section 41 and all of the second section 42 are located outside the second case 1, the second section 42 is arranged to be connected to an external circuit, and a length direction of the second section 42 is parallel to an end surface, provided with the via hole, of the second case 1. This design is helpful to increase an exposed connection area of the reference electrode 4, so as to advantageously connect the reference electrode 4 to the external circuit.

The second section 42 has a length of 3 cm-5 cm, a width of 1 cm-2 cm and a thickness of 0.05 cm-0.1 cm. In an embodiment, the second section 42 has a length of 3 cm, 3.5 cm, 4 cm, 4.5 cm, 5 cm, etc., a width of 1 cm, 1.5 cm, 2 cm, etc., and a thickness of 0.05 cm, 0.06 cm, 0.07 cm, 0.08 cm, 0.09 cm, 0.1 cm, etc. This design can make the second section 42 as flat as possible. Thus, the connection area of the second section 42 may be guaranteed, the second section 42 is thinner, and the connection is advantageous.

In an embodiment, after S204, S205 is further included: a position between the first section 41 and a wall of the via hole is filled with an insulating seal (not shown in figures). In an embodiment, the insulating seal is a tab adhesive. A gap between the first section 41 and the wall of the via hole is filled with the tab adhesive. Thus, a sealing performance of the second case 1 is guaranteed, the electrolyte is prevented from leaking, and the reference electrode 4 may be insulated and isolated from the wall of the via hole, so as to prevent potential existence between the reference electrode 4 and the second case 1 from interfering with the accuracy of the testing data.

In an embodiment, S3 specifically includes:
S301: A charge-discharge cycle operation is performed on all of the plurality of reference batteries.
S302. Corrosion failures of the plurality of reference batteries at different conditions are simulated respectively by connecting resistors that have different resistance values, a part of the resistors is connected between first positive electrodes and first cases of some of the plurality of reference batteries, another part of the resistors is connected between first negative electrodes and first cases of others of the plurality of reference batteries. Voltage changes to different degrees between the first positive electrodes and the first cases of all of the plurality of reference batteries are measured and recorded.
S303. A charge-discharge cycle is performed on each of the plurality of reference batteries for a preset period of time, each of the plurality of reference batteries is disassembled, whether the first case of each of the plurality of reference batteries is corroded is observed and determined, a voltage between the first positive electrode of the plurality of reference batteries and the first case of the plurality of reference batteries when each of the plurality of reference batteries is disassembled is measured, and the voltage range V₃ according to a voltage between the first positive electrode of the plurality of reference batteries and the first case of each of the plurality of reference batteries when each of the plurality of reference batteries is not corroded is obtained.

In this example, in S303, after each of the plurality of reference batteries is disassembled, whether the first case of each of the plurality of reference batteries is corroded is observed through a scanning electron microscope (SEM) and an energy dispersive spectrometer (EDS). The scanning electron microscope is used as an observation method that has resolution between resolution of a transmission electron microscope and resolution of an optical microscope. The scanning electron microscope scans a sample by using a narrow focused high-energy electron beam, stimulates various types of physical information through interaction between the beam and the substance, and characterizes micro-morphology of the first case of each of the plurality of reference batteries by collecting, amplifying and re-imaging the information. The energy dispersive spectrometer is an instrument for analyzing substance elements. Through combination of the scanning electron microscope and the energy dispersive spectrometer, observation of the micro-morphology and analysis of micro area composition of materials may be performed at the same time, and whether the first case is corroded is accurately determined accordingly.

### Embodiments for reference:

The following table shows a change in a voltage between a first positive electrode and a first case of a reference battery measured by externally connecting resistors to a plurality of reference batteries:

| Serial No. | A resistance value of the resistor externally connected between the first positive electrode and the first case | A resistance value of the resistor externally connected between a first negative electrode and the first case | A voltage between the first positive electrode and the first case | Corrosion state of the first case/storage for 6 months |
|---|---|---|---|---|
| 1 | 50 KΩ | Insulated | 0.02 V | Not corroded |
| 2 | 100 KΩ | Insulated | 0.02 V | Not corroded |
| 3 | 200 KΩ | Insulated | 0.24 V | Not corroded |
| 4 | 500 KΩ | Insulated | 0.66 V | Not corroded |
| 5 | 2 MΩ | Insulated | 0.98 V | Not corroded |
| 6 | 10 MΩ | Insulated | 1.16 V | Not corroded |
| 7 | 15 MΩ | Insulated | 1.30 V | Slightly corroded |
| 8 | Insulated | 100 KΩ | 3.12 V | Corroded |
| 9 | Insulated | 200 KΩ | 3.01 V | Corroded |
| 10 | Insulated | 500 KΩ | 2.68 V | Corroded |
| 11 | Insulated | 2 MΩ | 2.33 V | Slightly corroded |
| 12 | Insulated | 10 MΩ | 1.17 V | Not corroded |

In the table, resistors that have different resistance values are connected between the first positive electrodes of the plurality of reference batteries and the first cases of the plurality of reference batteries or between the first negative electrodes of the plurality of reference batteries and the first cases of the plurality of reference batteries. The plurality of reference batteries are disassembled after being stored for six months, so as to observe and determine the corrosion state of the first case of each of the plurality of reference batteries and the voltage between the first case and the first positive electrode when each of the plurality of reference batteries is disassembled.

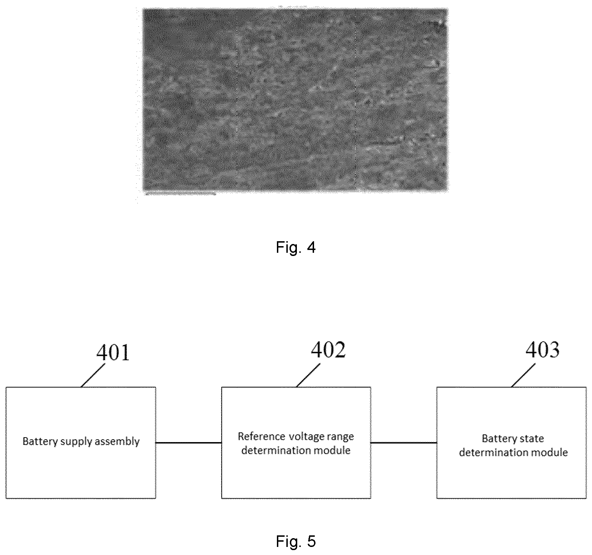

In the embodiment, whether the first case of each of the plurality of reference batteries is corroded is observed through the scanning electron microscope and the energy dispersive spectrometer. Fig. 3 is an SEM image of a non-corroded first case, and Fig. 4 is an SEM image of a corroded first case.

According to data in the table, the first case of each of the plurality of reference batteries is corroded when the voltage between the first positive electrode of each of the plurality of reference batteries and the first case of each of the plurality of reference batteries is between 1.16 V and 1.3 V. In consideration of unavoidable errors during measurement, in order to make the voltage range V₃ more accurate and reliable, the test may be repeated to obtain a more accurate and reliable V₃, and the first case of each of the plurality of reference batteries may be prevented from being corroded when V₃ is lower than 1.15 V.

As shown in Fig. 5, a battery testing apparatus according to the invention includes:
a battery supply assembly 401 configured to provide a tested battery, a plurality of reference batteries and a plurality of three-electrode batteries, where the tested battery includes a first case and electrodes; the electrodes include a first positive electrode and a first negative electrode, and the first positive electrode and the first negative electrode are both insulated from the first case; and the plurality of reference batteries have the same structure as the tested battery, each of the plurality of three-electrode batteries includes a second case, and a second positive electrode, a second negative electrode and a reference electrode that are all insulated from the second case, and the reference electrode is made from the same material as the first case;
a reference voltage range determination module 402 configured to determine a voltage range V₁ of plurality of reference batteries in a normal working state according to a voltage measured between a first positive electrode of each of the plurality of reference batteries and a first case of each of the plurality of reference batteries; measure a voltage between the second positive electrode and the reference electrode of each of the plurality of three-electrode batteries, and obtain a voltage range V₂ of the three-electrode battery in a normal working state; connect a resistor between one electrode of the first positive electrode of each of the plurality of reference batteries and a first negative electrode of each of the plurality of reference batteries, and the first case of each of the plurality of reference batteries, where resistance values of resistors connected to the plurality of reference batteries vary from one another; measure the voltage between the first positive electrode of each of the plurality of reference batteries and the first case of each of the plurality of reference batteries, and obtain a voltage range V₃ according to the voltage between the first positive electrode and the first case of each of the plurality of reference batteries when each of the plurality of reference batteries is not corroded; and obtain the reference voltage range V=V₃+(V₁-V₂) according to V₁, V₂ and V₃; and
a battery state determination module 403 configured to measure a tested voltage between the first positive electrode and the first case of the tested battery, determine whether the tested voltage is within the reference voltage range, and determine that the tested battery is normal in response to determining that the tested voltage is within the reference voltage range.

The invention further provides an electronic device. The electronic device includes at least one processor; and a memory in communication connection to the at least one processor, where the memory stores a computer instruction executable by the at least one processor, and the computer instruction causes the at least one processor to be capable of executing the battery testing method according to any example when executed by the at least one processor.

## Claims

1. A battery testing method, comprising:
providing a tested battery, wherein the tested battery comprises a first case and electrodes, the electrodes comprise a first positive electrode and a first negative electrode, and the first positive electrode and the first negative electrode are both insulated from the first case;
determining a reference voltage range; and
measuring a tested voltage between the first positive electrode and the first case of the tested battery, determining whether the tested voltage is within the reference voltage range, and determining that the tested battery is normal in response to determining that the tested voltage is within the reference voltage range; wherein
the determining a reference voltage range comprises:
providing a plurality of reference batteries that have the same structure as the tested battery, and determining a voltage range V₁ of the plurality of reference batteries in a normal working state according to a voltage measured between a first positive electrode of each of the plurality of reference batteries and a first case of each of the plurality of reference batteries;
providing a plurality of three-electrode batteries, wherein each of the plurality of three-electrode batteries comprises a second case, and a second positive electrode, a second negative electrode and a reference electrode that are all insulated from the second case, and the reference electrode is made from the same material as the first case; and measuring a voltage between the second positive electrode and the reference electrode of each of the plurality of three-electrode batteries, and obtaining a voltage range V₂ of the plurality of three-electrode batteries in a normal working state;
connecting a resistor between one electrode of the first positive electrode and a first negative electrode of each of the plurality of reference batteries, and the first case of each of the plurality of reference batteries, wherein resistance values of resistors connected to the plurality of reference batteries vary from one another; and
measuring a voltage between the first positive electrode of each of the plurality of reference batteries and the first case of each of the plurality of reference batteries, and obtaining a voltage range V₃ according to the voltage between the first positive electrode of each of the plurality of reference batteries and the first case of each of the plurality of reference batteries when each of the plurality of reference batteries is not corroded; and
obtaining the reference voltage range V=V₃+(V₁-V₂) according to V₁, V₂ and V₃.

2. The battery testing method as claimed in claim 1, wherein the providing the plurality of three-electrode batteries comprises:
providing the first case of each of the plurality of reference batteries which is qualified, cutting the first case of each of the plurality of reference batteries which is qualified into a strip-shaped piece, and polishing the strip-shaped piece;
coating an outer side of the strip-shaped piece with a first separator;
providing a core of each of the plurality of reference batteries, inserting an end of the strip-shaped piece into the core and forming the reference electrode; and
providing the second case and an electrolyte, mounting the core into the second case, injecting the electrolyte into the second case, packaging the second case, and obtaining each of the plurality of three-electrode batteries; wherein an end, far away from the core, of the reference electrode extends out of the second case.

3. The battery testing method as claimed in claim 2, wherein the second case is made from an aluminum-plastic film.

4. The battery testing method as claimed in claim 2, wherein the core comprises a positive plate, a negative plate and a second separator arranged between the negative plate and the positive plate;
the cutting the first case of each of the plurality of reference batteries which is qualified into the strip-shaped piece comprises: cutting the first case into the strip-shaped piece that comprises a first section and a second section that form an included angle therebetween; and
the inserting an end of the strip-shaped piece into the core comprises: inserting an end, far away from the second section, of the first section of the strip-shaped piece into the second case through a via hole that is provided in the second case, and further into a position between the negative plate and the second separator of the core.

5. The battery testing method as claimed in claim 4, further comprising: filling an insulating seal between the first section and a wall of the via hole.

6. The battery testing method as claimed in claim 4, wherein the second section of the strip-shaped piece has a length range of 3 cm-5 cm, a width range of 1 cm-2 cm and a thickness range of 0.05 cm-0.1 cm.

7. The battery testing method as claimed in any one of claims 1-6, wherein the connecting a resistor between one electrode of the first positive electrode and a first negative electrode, and the first case of each of the plurality of reference batteries, and measuring the voltage between the first positive electrode and the first case of each of the plurality of reference batteries, and obtaining a voltage range V₃ according to the voltage between the first positive electrode and the first case of each of the plurality of reference batteries when each of the plurality of reference batteries is not corroded comprise:
performing a charge-discharge cycle operation on each of the plurality of reference batteries;
simulating corrosion failures of the plurality of reference batteries respectively by connecting resistors, a part of the resistors is connected between first positive electrodes and first cases of some of the plurality of reference batteries, another part of the resistors is connected between first negative electrodes and first cases of others of the plurality of reference batteries; and
performing the charge-discharge cycle for a preset period of time, disassembling the plurality of reference batteries, observing and determining whether the first case of each of the plurality of reference batteries is corroded, measuring a voltage between the first positive electrode and the first case when each of the plurality of reference batteries is disassembled, and obtaining the voltage range V₃ according to the voltage between the first positive electrode and the first case of each of the plurality of reference batteries when each of the plurality of reference batteries is not corroded.

8. The battery testing method as claimed in claim 7, wherein the observing and determining whether the first case of each of the plurality of reference batteries is corroded comprise: observing whether the first case of each of the plurality of reference batteries is corroded through a scanning electron microscope and an energy dispersive spectrometer.

9. The battery testing method as claimed in any one of claims 1-6, wherein the reference voltage range is smaller than 1.3 V.

10. The battery testing method as claimed in claim 9, wherein V₁ is range from 0.5 V to 0.7 V, V₂ is range from 0.35 V to 0.5 V, and V₃ is smaller than 1.15 V.

11. A battery testing apparatus, comprising:
a battery supply assembly configured to provide a tested battery, a plurality of reference batteries and a plurality of three-electrode batteries, wherein the tested battery comprises a first case and electrodes; the electrodes comprise a first positive electrode and a first negative electrode, and the first positive electrode and the first negative electrode are both insulated from the first case; and the plurality of reference batteries have the same structure as the tested battery, each of the plurality of three-electrode batteries comprises a second case, and a second positive electrode, a second negative electrode and a reference electrode that are all insulated from the second case, and the reference electrode is made from the same material as the first case;
a reference voltage range determination module configured to determine a voltage range V₁ of the reference battery in a normal working state according to a voltage measured between a first positive electrode and a first case of each of the plurality of reference batteries; measure a voltage between the second positive electrode and the reference electrode of each of the plurality of three-electrode batteries, and obtain a voltage range V₂ of the three-electrode battery in a normal working state; connect a resistor between one electrode of the first positive electrode and a first negative electrode, and the first case of each of the plurality of reference batteries, wherein resistance values of resistors connected to the plurality of reference batteries vary from one another; measure a voltage between the first positive electrode and the first case of each of the plurality of reference batteries, and obtain a voltage range V₃ according to the voltage between the first positive electrode and the first case of each of the plurality of reference batteries when each of the plurality of reference batteries is not corroded; and obtain the reference voltage range V=V₃+(V₁-V₂) according to V₁, V₂ and V₃; and
a battery state determination module configured to measure a tested voltage between the first positive electrode and the first case of the tested battery, determine whether the tested voltage is within the reference voltage range, and determine that the tested battery is normal in response to determining that the tested voltage is within the reference voltage range.

12. An electronic device, comprising:
at least one processor; and
a memory in communication connection to the at least one processor; wherein
the memory stores a computer instruction executable by the at least one processor, and the computer instruction causes the at least one processor to be capable of executing the battery testing method as claimed in any one of claims 1-10 when executed by the at least one processor.
